# EUROPEAN PATENT APPLICATION

(11) **EP 0 660 399 A2**
(43) Date of publication of application: **28.06.1995**
(21) Application number: 94308577.9
(22) Date of filing: 21.11.1994
(51) Int. Cl.: H01L 23/367, H01L 23/31

(54) **Ball-grid-array integrated circuit package with thermal conductivity**

(30) Priority: 20.12.1993 US 170613
(71) Applicant: SGS-THOMSON MICROELECTRONICS, INC., Carrollton Texas 75006 (US)
(72) Inventor: Hundt, Michael J., Double Oak, Texas 75067 (US); Bond, Robert H., Plano, Texas 75023 (US)
(74) Representative: Palmer, Roger

(57) **Abstract**

An integrated circuit package with a path of high thermal conductivity is disclosed. The package is formed into a substrate, such as a printed circuit board or a ceramic substrate, through which an opening has been formed to receive a thermally conductive slug, formed of a material such as copper. An integrated circuit chip is mounted to one side of the slug, and the opposing surface of the slug is exposed at the underside of the substrate. The chip is wire bonded to the substrate, and is encapsulated in the conventional manner. Solder balls are attached to the underside of the substrate and of the slug in ball-grid-array fashion, for mounting to a circuit board. Upon mounting to the circuit board, a path of high thermal conductivity is provided between the chip and the circuit board, through the slug and the solder balls.

## Description

This invention is in the field of semiconductor device packages, and is more particularly directed to thermal conduction techniques therein.

Advances continue to be made in the manufacture of solid-state electronic devices, resulting in increasing functionality, density and performance of the integrated circuits. The amount of power dissipated, and accordingly the amount of heat generated, by modern integrated circuits generally increases with increases in the density and speed of the circuits. Removal of heat produced by the integrated circuits therefore continues to be of significant concern of modern integrated circuit package and system designers, considering the loss of performance and the degradation in reliability of integrated circuits when operated at elevated temperatures.

In addition, the trend toward more compact electronic systems is also continuing, exacerbating the thermal problem produced by the high-complexity and high-performance integrated circuits. For example, laptop or notebook sized computers have recently become quite popular, with continuing market pressure toward even smaller computer systems such as personal digital assistants (PDAs). However, these small systems eliminate many of the techniques for heat removal available for large-scale computer systems, such as the use of fans for convection cooling of the integrated circuits. As such, many modern systems utilize thermal conduction as the primary mode of heat removal from the integrated circuits in the system.

By way of further background, integrated circuit packages of the ball-grid-array (BGA) type have recently become popular in the field. Conventional BGA packages are similar in layout and arrangement to the pin-grid-array (PGA) packages, in providing a rectangular or square array of connections on the underside of the integrated circuit package. Instead of the pin connectors used in PGA packages, however, BGA packages utilize a solder ball located at each connector location. As is known in the art, the BGA package is attached to a printed circuit board by reflowing the solder balls to make connection to conductors at the surface of the printed circuit board. The BGA package provides the important advantage of being self-aligning, as the surface tension of the solder will tend to pull the BGA package into proper alignment with the corresponding conductors on the printed circuit board.

By way of further background, BGA integrated circuit packages of various types are known, including those of both the "cavity-up" and the "cavity-down" type. Conventional cavity-up BGA,packages mount the integrated circuit chip face-up into a cavity (or onto the surface) of the package substrate, attach wire bonds between the package and the chip on this top side, and then either transfer mold or otherwise dispense a plastic over the chip and bond wires to provide environmental protection to the chip and wires. The solder balls are provided on the side of the substrate opposite the chip, and the packaged chip is then mounted to the system printed circuit board. It is known to use plated vias through the substrate at locations underlying the chip, but that are offset from conductors on the printed circuit board to which the packaged chip is mounted, to provide thermal conduction from the chip to its external environment.

Conventional cavity-down integrated circuit packages mount the integrated circuit chip into the cavity of, or onto the surface of, the substrate, followed by attachment of bond wires thereto and molding of the plastic around the chip. In this type of package, the solder balls are provided on the same side of the substrate as the chip, so that the chip is disposed upside-down after attachment of the packaged chip to the circuit board. It is known to mount the chip to a thermally conductive slug disposed within the substrate of a cavity-down package, with the slug exposed on its opposite side from the chip after mounting. A heat sink may be mounted to the exposed upper surface of the slug, so that the heat sink extends upwardly and facilitates convection cooling. This arrangement is not particularly well suited for modern small computing systems, such as laptop, notebook-sized, or hand-held computers, as these systems are not able to house a fan, and indeed are designed to have no convection flow of air within the housing ("zero-air-flow").

It is therefore an object of the present invention to provide an integrated circuit package having improved thermal conduction from the packaged chip to the circuit board upon which it is mounted.

It is a further object of the present invention to provide such a package which is arranged in the cavity-up orientation.

It is a further object of the present invention to provide such a package that is of the ball-grid-array (BGA) type.

It is a further object of the present invention to provide such a package that reduces the need for convection cooling.

Other objects and advantages of the present invention will be apparent to those of ordinary skill in the art having reference to the following specification together with its drawings.

The invention may be implemented in a ball-grid-array (BGA) package of the cavity-up orientation. A thermally conductive slug, for example formed of copper, is inserted into a cavity of the package substrate; the substrate may itself be formed of a printed circuit board or ceramic substrate of the single, double, or multiple layer type. A surface of the slug is exposed on the underside of the substrate. The integrated circuit chip is attached to the slug, and bonds are made between the bond pads on the chip and the package conductors, followed by encapsulation of the chip by molding or dispensing of a plastic. Solder balls are attached on the underside of the package at locations corresponding to the terminals of the package, and also at locations on the exposed surface of the slug. Upon attachment to the system circuit board, thermal connection is made between the slug and system circuit board conductors, along with electrical connection of the other solder ball connectors to their respective system circuit board terminals. The slug thus provides direct thermal conduction between the chip and the system circuit board, to take advantage of the thermal conductivity of the system circuit board in conducting heat from the chip.

Some embodiments of the invention Will now be described by way of example and with reference to the accompanying drawings in which:

Figure 1 is a cross-sectional illustration of an integrated circuit package according to the preferred embodiment of the present invention.

Figure 2 is a plan view of the integrated circuit package according to Figure 1, including a cutaway portion.

Figure 3 is a cross-sectional illustration of an integrated circuit package according to an alternative preferred embodiment of the present invention.

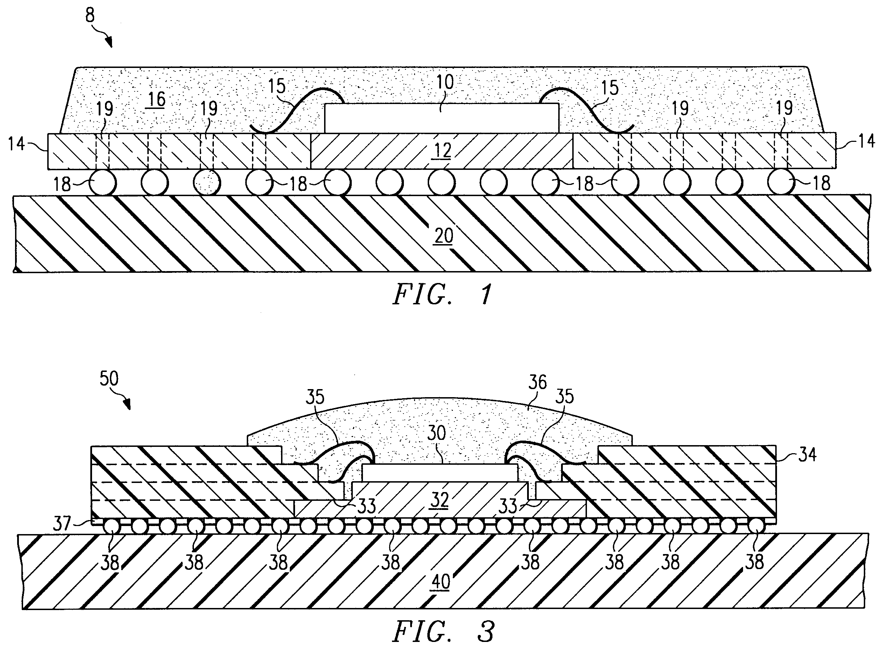

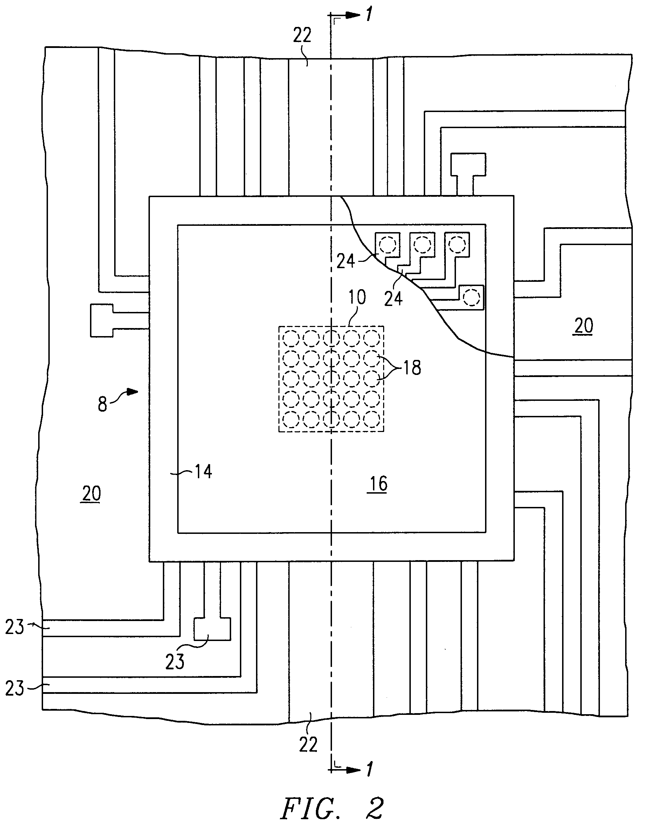

Referring now to Figures 1 and 2, packaged integrated circuit 8 according to a first preferred embodiment of the invention will now be described in detail. While packaged integrated circuit 8 according to this embodiment of the invention is shown in each of Figures 1 and 2 as already attached to system circuit board 20, it is to be understood by those of ordinary skill in the art that packaged integrated circuit 8 according to this embodiment of the invention will often individually manufactured and sold, with the purchaser performing the installation of packaged integrated circuit 8 to system circuit board 20 in a computer or other end equipment.

In addition, while the following description is provided using the example of a package containing a single integrated circuit chip, it is of course to be understood that the present invention is also applicable to the packaging or mounting of multiple integrated circuit chips to a board, for example in a hybrid integrated circuit or multichip module.

The active element of packaged integrated circuit 8 is semiconductor chip 10, which is a solid-state integrated circuit device such as a microprocessor, memory, logic device, analog device or other electronic function implemented in a single-chip integrated circuit, as known in the art. According to this embodiment of the invention, chip 10 is attached on its bottom (inactive) surface to conductive slug 12, mounted within substrate 14.

Substrate 14 may be a ceramic substrate, printed circuit board, or other similar substrate having conductors 24 thereupon or therewithin (see Figure 2) for carrying electrical signals to and from chip 10, and having an opening or receptacle therein within which conductive slug 12 is mounted. Bond wires 15 connect conductors 24 to bond pads on chip 10 in the conventional manner. Plated-through vias 19 make connection between conductors 24 on the top surface of substrate 14 and solder balls 18 on the lower surface of substrate 14. According to this embodiment of the invention, solder balls 18 are arranged in the conventional ball-grid-array manner, and correspond to lands or other surface conductors 23 (see Figure 2) on the top surface of system circuit board 20 to which packaged integrated circuit 8 is to be mounted. Encapsulant 16, formed of a plastic mold compound, an epoxy, a potting compound, or other conventional integrated circuit encapsulant, covers chip 10 and wires 15 to provide environmental and mechanical protection therefor.

Conductive slug 12 is preferably formed of a material with high thermal conductivity, so that heat from chip 10 may be readily conducted therethrough. In addition, if electrical connection is to be made to the body of chip 10, conductive slug 12 is also preferably electrically conductive. The preferred material for conductive slug 12 is believed to be copper, but other materials known in the art to be thermally conductive and, if desired, electrically conductive, may alternatively be used for slug 12.

Solder balls 18 are also disposed in an array manner beneath and in contact with slug 12, for providing thermal connection between slug 12 and a thermal conductor in system circuit board 20. In the example of Figure 2, conductive trace 22 is a wide trace on system circuit board 20 that is capable of conducting heat from chip 10 via slug 12 and solder balls 18. Alternatively, where system circuit board 20 is of multilayer construction, slug 12 may be connected by solder balls 18 to a ground plane within system circuit board 20. In either case, conductor 22 or the ground plane may be biased to ground or another substrate bias voltage, in which case slug 12 will also provide proper grounding for chip 10.

The fabrication of packaged integrated circuit 8 begins with the insertion of slug 12 into the corresponding cavity of substrate 14; slug 12 is preferably epoxied into this cavity for mechanical integrity. Chip 10 is then mounted to the top surface of slug 12 by conventional die attach techniques, such as a conductive epoxy or eutectic mount. Bond wires 15 are then attached between substrate 14 and chip 10 by conventional techniques, such as thermocompression or ultrasonic bonding. Upon completion of the wire bond process, encapsulant 16 is formed over chip 10 and wires 15 in the conventional manner. In the example of Figures 1 and 2, encapsulate 16 is formed by conventional transfer molding; alternatively, encapsulant 16 may be "globbed" over chip 10 and substrate 14 by dispensation and curing, in the conventional manner. Solder balls 18 are formed on the underside of substrate 14 and slug 12, in the conventional manner, for example by way of a solder mask (not shown) on the underside of substrate 14.

Upon completion of the construction of packaged integrated circuit 8, and any desired electrical testing in packaged form, packaged integrated circuit 8 is ready for mounting to system circuit board 20. Mounting of packaged integrated circuit 8 is preferably done by way of wave soldering or other conventional technique for the surface mounting of BGA packages to circuit boards.

Figure 3 illustrates, in cross-section, packaged integrated circuit 50 according to a second embodiment of the invention. According to this embodiment of the invention, packaged integrated circuit 50 includes chip 30 mounted upon thermally conductive slug 32. Slug 32 is disposed within substrate 34, which in this example is a multilayer circuit board including multiple levels of conductors therewithin. The multiple levels of conductors in substrate 34 are presented by multiple shells of lands, as indicated by the stepped arrangement near the chip cavity of substrate 34. A cutout is provided on the underside of substrate 34, to provide lateral surfaces 33 to which slug 32 may be epoxied or otherwise securely fastened. In this arrangement, slug 32 includes a smaller portion protruding through substrate 34, to which chip 30 is mounted, with larger exposure on the underside of substrate 34. This construction allows for slug 32 to be the proper size for receipt of chip 30 on its top size, providing the maximum area for the arrangement of bond wire lands on substrate 34 with minimum wire length, while maximizing the surface area of thermal conduction on the underside.

Bond wires 35 electrically connect conductors (not shown) in substrate 34 to pads on the surface of chip 30, for connection to the multiple planes of conductors. In this embodiment of the invention, encapsulant 36 is disposed over the cavity of substrate 34, and thus over chip 30 and wires 35. Encapsulant 36 according to this embodiment of the invention is dispensed by way of a syringe or other liquid dispenser, and is then cured in the conventional manner for so-called "chip-on-board" construction.

Solder balls 38 are attached to lands on the bottom surface of substrate 34. Vias (not shown) are provided within substrate 34 to provide electrical connection to the conductors in the substrate. Solder mask 37 on the underside of substrate 34 assists in defining the location of solder balls 38, during their formation in the conventional manner.

As in the first embodiment discussed hereinabove, packaged integrated circuit 50 is attached to system circuit board 40 by way of infrared (IR) solder reflow or other conventional surface mount technology. Those solder balls 38 that are in contact with slug 32 connect to a thermal conductor within system circuit board 40, thus providing a path of relatively low thermal resistance between chip 30 and system circuit board 40 through solder balls 38 and slug 32.

According to each of these embodiments of the invention, an integrated circuit package is provided which has a high thermal conductivity path is provided between the active integrated circuit therewithin and the system circuit board to which the packaged integrated circuit is mounted. This enables the advantageous use of the system circuit board thermal conductivity to remove heat from the integrated circuit chip via conduction, and as such is suitable for use in zero-air-flow environments such as notebook-size computers, hand-held computing devices such as PDAs, and the like.

While the invention has been described herein relative to its preferred embodiments, it is of course contemplated that modifications of, and alternatives to, these embodiments, such modifications and alternatives obtaining the advantages and benefits of this invention, will be apparent to those of ordinary skill in the art having reference to this specification and its drawings. It is contemplated that such modifications and alternatives are within the scope of this invention as subsequently claimed herein.

## Claims

1. A packaged integrated circuit, comprising:
a substrate having first and second surfaces, having a opening disposed therethrough, and having a plurality of electrical conductors;
a slug, comprised of a thermally conductive material and having first and second surfaces, said slug extending through the opening of said substrate so that its first surface is exposed at said first surface of said substrate;
an integrated circuit chip, mounted to the second surface of said slug, and electrically connected to the conductors of said substrate;
a plurality of electrical connectors, disposed at the first surface of said substrate, and in electrical connection with the conductors of said substrate, said plurality of electrical connectors for making connection to a circuit board; and
a thermal conductor, disposed at the first surface of said slug, for making thermal connection to the circuit board.

2. The packaged integrated circuit of claim 1, wherein said plurality of electrical connectors comprise a plurality of solder balls.

3. The packaged integrated circuit of claim 2, wherein said thermal conductor comprises a plurality of solder balls.

4. The packaged integrated circuit of claim 1, further comprising:
an encapsulant, disposed over said integrated circuit chip and over a portion of the second surface of said substrate.

5. The packaged integrated circuit of claim 4, wherein said encapsulant comprises molded plastic.

6. The packaged integrated circuit of claim 1, wherein said substrate comprises a printed circuit board.

7. The packaged integrated circuit of claim 6, wherein said printed circuit board is of the multilayer type.

8. The packaged integrated circuit of claim 1, wherein said substrate comprises a ceramic substrate.

9. The packaged integrated circuit of claim 8, wherein said ceramic substrate is of the multilayer type.

10. The packaged integrated circuit of claim 1, wherein said slug comprises copper.

11. The packaged integrated circuit of claim 1, wherein the first surface of said slug has a surface area greater than the second surface of said slug.

12. A method of fabricating a packaged integrated circuit, comprising:
inserting a thermally conductive slug into a substrate having first and second opposing surfaces, said thermally conductive slug having a first surface exposed at the first surface of the substrate, and having a second surface opposite therefrom;
mounting an integrated circuit chip to the second surface of the thermally conductive slug;
encapsulating said integrated circuit chip;
attaching electrical connectors to the substrate at its first surface; and
attaching a thermal conductor to the slug at its first surface.

13. The method of claim 12, wherein the step of attaching electrical connectors to the substrate comprises attaching solder balls to the substrate at its first surface.

14. The method of claim 13, wherein the step of attaching a thermal conductor to the slug comprises attaching solder balls to the slug at its first surface.

15. The method of claim 12, wherein the encapsulating step comprises:
transfer molding a plastic mold compound over said chip.

16. The method of claim 12, wherein the encapsulating step comprises:
dispensing a plastic over said chip; and
curing the dispensed plastic.

17. The method of claim 12, wherein the step of attaching electrical connectors to the substrate and the step of attaching a thermal conductor to the slug comprise attaching solder balls to the substrate and to the slug at their respective first surfaces;
and further comprising:
attaching the packaged integrated circuit to a circuit board.
